# EUROPEAN PATENT APPLICATION

(11) **EP 1 617 287 A1**
(43) Date of publication of application: **18.01.2006**
(21) Application number: 04723709.4
(22) Date of filing: 26.03.2004
(51) Int. Cl.: G03F 1/08, H01L 21/027, B05C 11/10

(54) **METHOD OF MANUFACTURING MASK BLANK**

(30) Priority: 28.03.2003 JP 2003090681
(71) Applicant: HOYA CORPORATION, Shinjuku-ku, Tokyo 161-8525 (JP)
(72) Inventor: HATA, Mitsuaki, c/o HOYA CORPORATION, Tokyo 161-8525 (JP)
(74) Representative: Vossius & Partner
(86) International application number: PCT/JP2004/004272
(87) International publication number: WO 2004/088418

(57) **Abstract**

A method for manufacturing a mask blank by depositing a film of a resist liquid on a substrate having a thin film functioning as a transfer pattern by a spin-coating process, covering the substrate with a covering member, and performing removal by dissolving of an unnecessary part of the resist film by supplying a solvent from above the covering member during the rotation of the substrate and the covering member together so that the solvent is supplied to the periphery of the substrate, wherein a reduced-pressure-drying process for the resist film deposited by the spin-coating process is performed before the unnecessary-film-removing process of removing the unnecessary part of the resist film by dissolving so that a deterioration in the within-film thickness uniformity of the resist film caused by the unnecessary-film-removing process is suppressed.

## Description

### Technical Field

The present invention relates to methods for manufacturing mask blanks. According to the methods, unnecessary parts deposited on the peripheries of substrates can be removed from resist films formed on the substrates having thin films.

### Background Art

In general, coated films such as resists are deposited on substrates for mask blanks by coating resist liquids on the substrates during the rotation of the substrates, i.e. a spin-coating method is usually used (see, for example, Japanese Examined Patent Publication (JP-B) No. 4-29215 (pages 2 and 3, Fig. 2)).

The spin coating method disclosed in this Patent Document includes a dropping process for dropping a resist liquid onto a thin-film surface of a substrate, a uniformizing process for uniformizing a film thickness of the resist liquid deposited on the thin-film surface of the substrate by rotating the substrate at a predetermined rotating speed for a predetermined period of time, and a preliminary-drying process for preliminarily drying the film of the resist liquid by rotating the substrate at a predetermined rotating speed for a predetermined period of time after the uniformizing process. The resist film is formed on the substrate through these processes. According to this spin-coating method, in-plane film thickness uniformity of the resist film (a difference in the maximum thickness and the minimum thickness in the substrate plane) can be suppressed to 50 Å or less.

When the resist liquid is coated on the substrate by the above-mentioned spin-coating method, the resist liquid is accumulated at the periphery of the substrate surface. Therefore, the resist liquid possibly reaches not only the side faces but also the rear face of the substrate. Since the resist films formed on such regions tend to peel or fall during the processing of the substrate, such resist films cause defects in products and also prevent the holding of the substrate in a post-process. Consequently, proposal is made of methods for removing unnecessary parts deposited on the periphery of the substrate from the resist film deposited on the substrate (see, for example, Japanese Unexamined Patent Application Publication (JP-A) No. 2001-259502 (page 5, Fig. 1)).

In the unnecessary-film-removing method disclosed in this Patent Document, a substrate having a resist film is covered by a covering member having a great number of small pores at the periphery, and a solvent is applied from above this covering member to the periphery of the substrate through the small pores during the rotation the substrate and the covering member together. Thus, the unnecessary parts of the resist film are removed by dissolving.

In the above-mentioned unnecessary-film-removing method, in order to suppress unevenness in sensitivity of the resist caused by heat transmission of the covering member, the covering member is made of a material having a low heat transmission (for example, a resin material or a glass material) and a gap between the inner wall of the covering member and the surface of the substrate is determined so as to suppress the heat transmission from the covering member to the substrate.

Additionally, upon manufacturing large-size substrates such as liquid crystal substrates, a reduced-pressure-drying process may be performed before the unnecessary-film-removing process (see, for example, Japanese Patent (JP-B) No. 3309079 (page 2, Fig. 2)).

In the large-size substrates, in general, the coating of the resist liquid is performed in an enclosed coating apparatus, and the preliminary drying of the resist liquid cannot be sufficiently performed in the coating apparatus. Therefore, the resist films are necessarily dried to some extent under reduced pressure for suppressing the flow of the resist films during a substrate-conveying process later. Namely, the drying of the large-size substrates under reduced pressure in manufacturing processes is a process corresponding to the preliminary-drying process of the spin-coating processes in the manufacturing of small-size substrates such as mask blanks.

Recently, as the miniaturization of transfer patterns progresses, requirement for in-plane-film thickness uniformity of the resist films in mask blanks has been increased. Specifically, in order to suppress the critical dimension variation (CD-variation), the in-plane-film thickness uniformity of the resist films is required to be 50 A or less.

However, even if the resist film after the spin-coating has a in-plane-film thickness uniformity of 50 Å or less, the uniformity of the film thickness is deteriorated in the unnecessary-film-removing process and the in-plane-film thickness uniformity problematically exceeds 100 Å. The causes of this problem are understood as follows.

In the unnecessary-film-removing method disclosed in Japanese Unexamined Patent Application Publication (JP-A) No. 2001-259502, the solvent is supplied on the covering member covering the substrate. Therefore, the central part of the covering member has a relatively high temperature, and the covering member has a temperature distribution that the temperature decreases toward the periphery of the covering member. This temperature distribution is transmitted to the resist film of the substrate. Such heat transmission can be suppressed by selecting material of the covering member or forming enough gap between the covering member and the substrate, but the heat transmission cannot be completely prevented.

The resist film deposited on the substrate is preliminarily dried in the spin-coating process, but contains a large amount of the solvent in the unnecessary-film-removing process. Therefore, when the unnecessary film is removed during the rotation of the substrate, the temperature distribution or a centrifugal force causes a flow of the resist from the central part of the substrate where the temperature is relatively high toward the periphery of the substrate where the temperature is relatively low. Thus, it is assumed that the film thickness locally changes to deteriorate the in-plane -film thickness uniformity.

It is an object of the present invention to provide a method for manufacturing mask blanks which can suppress local variation of a resist film in thickness due to the temperature distribution or the centrifugal force upon the removal by dissolving of unnecessary parts of the resist film to thereby prevent deterioration of in-plane-film thickness uniformity of a resist film.

It is an another object of the present invention to provide mask blanks including a resist film having a uniform thickness at a region where a transfer pattern is formed.

### Disclosure of Invention

In order to achieve the above-mentioned objects, according to the present invention, there is provided a method for manufacturing a mask blank by depositing a film of a resist liquid on a substrate including a thin film functioning as a transfer pattern by a spin-coating process; covering the surface of the substrate with a covering member; and performing removal by dissolving of an unnecessary part of the resist film by supplying a solvent from above the covering member during the rotation of the substrate and the covering member together so that the solvent is supplied to the periphery of the substrate, wherein:
a reduced-pressure-drying or a vacuum-drying process for the resist film deposited in the spin-coating process is performed before the unnecessary-film-removing process for removing the unnecessary part of the resist film by dissolving so that a deterioration in an in-plane-film thickness uniformity of the resist film caused by the unnecessary-film-removing process is suppressed.

According to such a method, the resist film at the pattern-forming area is dried by the reduced-pressure-drying process performed before the unnecessary-film-removing process to the extent not to flow by the temperature distribution in the unnecessary-film-removing process or the centrifugal force. This can suppress the partial change in the film thickness of the resist film caused by the unnecessary-film-removing process and can prevent the deterioration in plane-film thickness uniformity of the resist film.

The process conditions such as a degree of vacuum, time, and atmosphere temperature in the reduced-pressure-drying process are appropriately determined according to the types of resist and the film thickness. The degree of vacuum is 10 kPa or less, preferably 5 kPa or less, and more preferably 2 kPa or less.

The reduced-pressure-drying process is preferably performed at a state where the periphery of the resist film is dried to some extent and that the resist- film in the pattern-forming area is stable. With such reduced-pressure-drying process, the flatness in the pattern-forming area of the resist film can be improved.

Further, in the method for manufacturing the mask blank according to the present invention, the spin-coating process is performed in a cup having an opening on an upside by dropping a resist liquid on the surface of the substrate, rotating the substrate at a predetermined rotating speed for a predetermined period of time in order to uniform the film thickness of the resist liquid, and rotating the substrate at a predetermined rotating speed for a predetermined period of time in order to preliminarily dry the film of the resist liquid.

With such a method, the preliminary drying of the resist film in the spin-coating process can be enhanced by performing the spin coating of the resist liquid in the cup having an opening on the upside. Therefore, the flow of the resist film in the substrate-conveying process performed later can be suppressed, and the time spent for the reduced-pressure-drying process can be also reduced.

Further, in the method for manufacturing the mask blank according to the present invention, the rotating speed of the substrate for the preliminary drying of the film of the resist liquid is lower than that for uniformizing the film thickness of the resist liquid in the spin-coating process.

With such a method, the film of the resist liquid can be preliminarily dried while the uniformized film thickness is maintained. Furthermore, a resist film having a uniform thickness can be deposited on a quadrilateral (square or rectangle) substrate.

Further, in the method for manufacturing the mask blank according to the present invention, an airstream from the upside of the cup toward the substrate is generated by exhausting at the downside of the cup in the spin-coating process.

With such a method, the uniformizing of the film thickness in the spin-coating process and the preliminary drying of the resist film by the rotation can be further enhanced by the airstream generated from the upside of the cup toward the substrate.

Further, in the method for manufacturing the mask blank according to the present invention, the degree of vacuum in a substrate-receiving space is stepwise decreased in the reduced-pressure-drying process.

With such a method, the solvent contained in the resist film can be uniformly dried while a sharp change in pressure is avoided. Therefore, the uniformity of the film thickness of the resist film can be improved.

For example, preferably, the degree of vacuum is gradually decreased to a certain degree, and the certain degree of vacuum is maintained. Then, the degree of vacuum is gradually increased to atmospheric pressure.

According to the present invention, there is provided a method for manufacturing a mask blank, comprising:
depositing a resist liquid dropped on a substrate having a thin film by a spin-coating process;
forming a resist film by drying the deposited film of the resist liquid by a spin-drying process;
drying the resist film by a reduced-pressure-drying process;
supplying a solvent for dissolving the resist film to a periphery of the mask blank on which the resist film is formed; and
removing the resist film at the periphery by rotating the mask blank.

The resist film is exposed to reduced pressure before the periphery of the resist film is removed by dissolving. This enhances evaporation of the solvent contained in the resist film. Thus, the drying can be enhanced. After the reduced-pressure-drying process, the solvent is supplied to the periphery of the resist film for a spin-removing process. By the spin-removing process, the flow of the resist from the central part to the periphery of the substrate can be prevented. Therefore, the formation of a resist film having a concave at the central part of the mask blank can be avoided.

The resist film at an area on the mask blank where a transfer pattern is formed can has a uniform thickness after the removing process. As a result, the difference (in-plane-film thickness uniformity) between the maximum thickness and the minimum thickness of the resist film at that area can be adjusted to 50 A or less. Hereinbelow, the area on the mask blank where a transfer pattern is formed will be referred to as an effective area.

In the present invention, the reduced-pressure-drying process can be performed to the substrate in the stationary state. As described above, the reduced-pressure-drying process can promote the operation of the present invention.

In the present invention, the spin-drying process is preferably performed before the reduced-pressure-drying process.

The rotating speed of the substrate in the spin-drying process performed prior to the reduced-pressure-drying process may be lower than that in the spin-coating for depositing a film of the resist liquid. Thus, the thickness of the resist film on the mask blank to which the reduced-pressure drying is performed can be uniformized by previously performing the spin-drying. Furthermore, a quadrate, for example, quadrangular, square, or rectangular substrate can be also provided with a resist film having a uniform thickness.

In the present invention, in particular, it is preferable that the resist film on the mask blank to which the reduced-pressure drying is performed has a difference between the maximum film thickness and the minimum film thickness (an in-plane-film thickness uniformity) of 50 Å or less at the effective area.

In the present invention, the mask blank is heated to dry the resist film after the resist film at the periphery is removed. This surely dries the resist film.

According to the present invention, a mask blank, which is prepared by depositing a resist film on a substrate having a thin film, can be manufactured. In particular, the mask blank can be suitably used as a mask blank for a transfer mask such as an ArF excimer laser exposure mask, F₂ excimer laser exposure mask, and extreme ultraviolet rays (EUV) exposure mask.

### Brief Description of the Drawings

Fig. 1 is a flow chart of manufacturing processes of mask blanks.
Fig. 2 is a schematic view of a basic structure of a spin-coating apparatus.
Fig. 3 is a schematic view of a basic structure of a reduced-pressure drier.
Fig. 4 is a schematic view of a basic structure of an unnecessary-film-removing apparatus.

### Best Mode for Carrying Out the Invention

Embodiments according to the present invention will now be described with reference to the drawings.

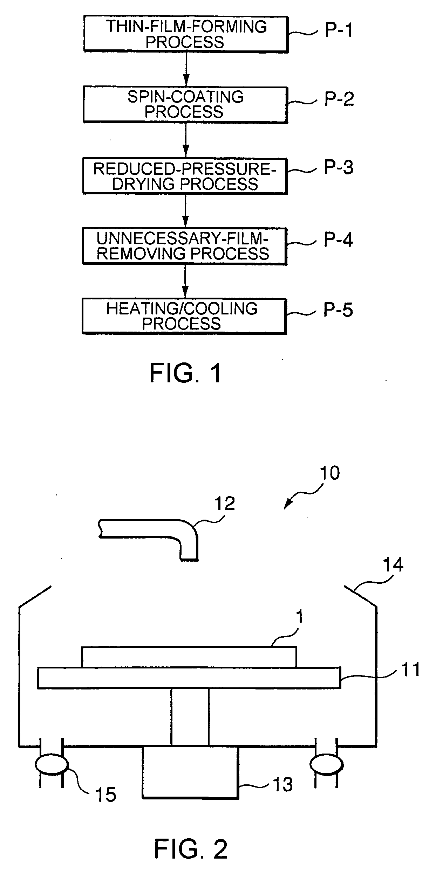

Fig. 1 is a flow chart of manufacturing processes of mask blanks.

With reference to Fig. 1, the mask blank-manufacturing processes include a thin-film-forming process (P-1) for forming a thin film functioning as a transfer pattern on a surface of a substrate for a mask blank, a spin-coating process (P-2) for depositing a resist film on the surface of the substrate 1 provided with the thin film by spin coating, a reduced-pressure-drying process (P-3) for suppressing a variation in thickness of the resist film in an unnecessary-film-removing process, the unnecessary-film-removing process (P-4) for removing an unnecessary resist film deposited at the periphery of the substrate, and a baking/cooling process (P-5) for drying the resist film by baking and cooling.

Mainly, the characteristics of the present invention exist in the reduced-pressure-drying process (P-3) and the unnecessary-film-removing process (P-4). The variation in thickness of the resist film can be further suppressed by performing the spin-coating process (P-2) under predetermined conditions. Each process (P-1 to P-5) will now be described.

### [Thin-film-forming process (P-1)]

The thin film functioning as a transfer pattern is deposited by sputtering, vacuum evaporation, or CVD. The material for the thin film functioning as a transfer pattern is appropriately determined according to the types of the mask blanks.

The mask blanks can be classified to transmission type mask blanks and reflection type mask blanks.

In the transmission type mask blanks, a transparent substrate such as a glass substrate is used as the substrate. The thin film functioning as a transfer pattern is a thin film causing an optical change against exposure light when the pattern is transferred. Examples of the thin film causing an optical change against exposure light include a light-shielding film which shields the exposure light and a phase-shifting film which changes the phase-shift difference of the exposure light.

Therefore, the mask blanks in the present invention include, in addition to binary photomask blanks with a light-shielding film as a thin film having a light-shielding function, phase-shifting mask blanks (halftone type phase-shifting mask blanks) provided with a halftone film as a thin film having a light-shielding function and phase-shifting mask blanks provided with a phase-shifting film.

The reflection type mask blanks comprises a light-reflective multilayer film and a light-absorbing film functioning as a transfer pattern on a low-expansion substrate.

Furthermore, the mask blanks may be provided with, in addition to the above-mentioned film, a bottom anti-reflective coating (BARC), a top anti-reflective layer (TARL), a top protective film, or a conductive film.

### [Spin-coating process (P-2)]

In the spin-coating process (P-2), a resist film is uniformly deposited on a substrate having a thin film by using a spin-coating apparatus described below. Since the mask blank substrate is generally a square such as a quadrilateral, the spin-coating process includes at least the following two steps:

A uniformizing step of dropping a resist liquid on the substrate and of rotating the substrate at a predetermined rotating speed (main rotating speed) for a predetermined period of time (main rotating time) in order to mainly uniform the film thickness of the resist liquid, and a preliminary-drying step of mainly drying the film of the resist liquid uniformed in the uniformizing step by rotating the substrate at a predetermined rotating speed (drying rotating speed) for a predetermined period of time (drying rotating time).

These main rotating speed, main rotating time, drying rotating speed, and drying rotating time are determined according to the types of the resists.

Specifically, the resist film having an in-plane-film thickness uniformity of 50 Å or less is prepared under conditions as follows:
Main rotating speed R1: 750 to 1800 rpm
Main rotating time T1: 1 to 30 sec
Drying rotating speed R2: 50 to 1500 rpm
Drying rotating time T2: 10 sec or more

Fig. 2 is a schematic view of a basic structure of a spin-coating apparatus.

As shown in Fig. 2, the spin-coating apparatus 10 is provided with a chuck 11 for holding the substrate 1 on which a thin film is formed, a nozzle 12 for dropping the resist liquid, a motor 13 for rotating the chuck 11, a cup 14 for preventing the dropped resist liquid from scattering in all directions by the rotation, and an exhausting mechanism 15 for exhausting at the downside of the cup 14 in order to generate the air flow from the upward of the cup 14 towards the substrate 1.

First, the substrate 1 is held on the chuck 11 of the spin-coating apparatus 10, before a resist liquid is deposited on the substrate 1 having a thin film. Then, after the dropping of the resist liquid from the nozzle 12, the substrate 1 is rotated at main rotating speed R1 for main rotating time T1 in order to uniformly spread the dropped resist liquid on the substrate 1.

After main rotating time T1 passed, the rotating speed is changed to drying rotating speed R2 for drying the resist liquid. This process ends when drying rotating time T2 passed. In the preliminary-drying process, the resist film deposited on the substrate 1 is not completely dried, but dried enough so that the resist film formed at the periphery of the substrate 1 does not have fluidity. This stabilizes the resist film at a pattern-forming area.

After the dropping of the resist liquid, the exhausting is performed by the exhausting mechanism 15 at the downside of the cup 14 from the start to the end of the rotation of the substrate 1 so that the air flows against the substrate 1 from the upside of the cup 14. The velocity of the airstream is determined by the exhausting conditions of the exhausting mechanism 15, specifically, a velocity of the airstream of 1 m/sec or more is preferable for uniformizing the resist film.

### [Reduced-pressure-drying process (P-3)]

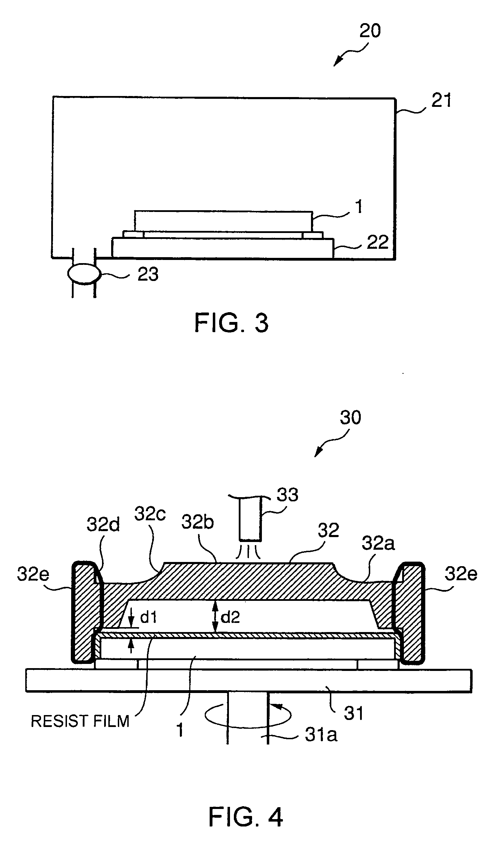

Fig. 3 is a schematic view of a basic structure of a reduced-pressure drier.

As shown in Fig. 3, the reduced-pressure apparatus 20 is provided with a chamber 21 for maintaining a substrate-receiving space reduced-pressure atmosphere, a substrate-holding means 22 for holding the substrate 1 in the chamber 21, and an exhausting mechanism 23 for exhausting at the downside of the chamber 21 to maintain the substrate-receiving space a reduced-pressure state.

When the resist film deposited on the substrate 1 in the spin-coating process is dried by the reduced-pressure apparatus 20, the substrate 1 is set on the substrate-holding means 22 and then the pressure in the chamber 21 is reduced under predetermined conditions. In this reduced-pressure-drying process, the resist film deposited on the substrate 1 is not completely dried, but is dried enough so that the resist film formed at the pattern-forming area is controlled not to flow by a temperature distribution or a centrifugal force in the subsequent unnecessary-film-removing process.

The reduced-pressure apparatus 20 may further have a heating means for heating the substrate 1 during the reduced-pressure drying of the substrate 1.

In the reduced-pressure-drying process, preferably, the degree of vacuum in the substrate-receiving space is gradually changed. For example, preferably, the degree of vacuum is gradually increased to a certain degree, and the certain degree of vacuum is maintained. Then, the degree of vacuum is gradually decreased to atmospheric pressure. With such a process, the solvent contained in the resist film can be uniformly evaporated while a sharp change in pressure is avoided. Therefore, the deterioration in the in-plane-film thickness uniformity of the resist film can be prevented.

Furthermore, the in-plane-film thickness uniformity of the pattern-forming area of the resist film can be further improved by drying the resist film under reduced pressure after that the periphery of the resist film is dried to some degree and that the resist film of the pattern-forming area is stabilized.

### [Unnecessary-film-removing process (P-4)]

Fig. 4 is a schematic view of a basic structure of an unnecessary-film-removing apparatus.

As shown in Fig.4, the unnecessary-film-removing apparatus 30 comprises a rotating table 31 for holding the substrate 1 and rotating it, a covering member 32 for covering the substrate 1 held on the rotating table 31 from the upside of the substrate and being rotated in synchronization with the rotating table 31, and a nozzle 33 for supplying a solvent from the upside of the covering member 32.

In the unnecessary-film-removing process, the substrate 1 on which the resist film was deposited is covered with the covering member 32, and the solvent is supplied from the upside of the covering member 32. The solvent is supplied to the periphery of the substrate 1 during the rotation of the substrate 1 and the covering member 32 together. Thus, the unnecessary part of the resist film is removed by dissolving.

The covering member 32 covers the substrate 1 from the upside. The top face of the covering member 32 is entirely flat, but has a circular channel 32a at the periphery. The solvent supplied from the nozzle 33 reaches the channel 32a through a central part 32b and a sloping part 32c of the covering member 32 and then stays in the channel 32a.

The bottom of the channel 32a is provided with a large number of solvent-supplying holes 32d of through-holes. The solvent is supplied to the periphery of the substrate 1 via the solvent-supplying holes 32d.

Some of the solvent-supplying holes 32d at several positions are threaded with strings 32e that are resistive to the solvent. These strings 32e intervene between a ceiling face periphery (unnecessary-film-facing part) of the covering member 32 and a surface (periphery) of the substrate 1 to secure a gap d1 between them. The strings 32e are threaded through solvent-supplying holes 32d, pass through between the ceiling face periphery of the covering member 32 and the surface of the substrate 1 and between the inside face of the covering member 32 and the side face of the substrate 1, and pass through the external part of the covering member 32 to be made into a loop.

The size of the strings 32e is determined based on the gap d1 so that a solvent-extending range is regulated by meniscus when the solvent is supplied to the gap between the ceiling face periphery of the covering member 32 and the surface of the substrate 1. For example, the gap d1 is between 0.05 mm and 3 mm.

The ceiling face of the covering member 32 except the periphery faces the pattern-forming area of the substrate 1. In this area, a gap d2 between the ceiling face of the covering member 32 and the surface of the substrate 1 is larger than the gap d1 between ceiling face periphery and the surface of the substrate 1. The gap d2 is preferably determined so that the heat transmission of the temperature distribution in the covering member 32 to the resist film of the substrate 1 is avoided and that the occurrence of temperature distribution in the resist film of the substrate 1 is prevented by convection generated in the gap. For example, the gap d2 is determined within the range of 0.05 to 20 mm.

The substrate 1 covered with the covering member 32 is treated during the rotation together with the rotating table 31. The rotating table 31 is attached to a rotating shaft 31 a. The rotating table 31 is provided with not shown four supporting arms extending in a radial pattern in the horizontal direction and a pair of not shown supporting seats disposed to each end of the supporting arms, and holds the substrate 1 by arranging four corners of the substrate 1 on the supporting seats. The rotating shaft 31 a is connected to a rotation-driving device (not shown) and is rotated at a predetermined speed.

A bottom nozzle (not shown) for supplying a solvent is provided at the lower side of the substrate 1. The unnecessary film is surely removed by supplying the solvent from the bottom nozzle.

The unnecessary resist film deposited on the periphery of the substrate 1 is removed by using the unnecessary-film-removing apparatus 30 as follows:

At first, the substrate 1 is mounted on the rotating table 31 and is covered with the covering member 32. A solvent is supplied from the nozzle 33 as an amount of the supply is controlled. At the same time, the rotating table 31 is rotated at a rotating speed of 100 to 1000 rpm for 1 to 60 sec. In this manner, the solvent penetrates to the unnecessary film area through the solvent-supplying holes 32d and removes the film by dissolving. Furthermore, in the closing stage of the process, the bottom nozzle ejects the solvent to surely perform the removal by dissolving.

### [Baking/cooling process (P-5)]

After the unnecessary-film-removing process, the substrate 1 is conveyed to the following heat-treating (baking) apparatus for performing the baking/cooling process. Thus, the resist film is completely dried to obtain a mask blank in which the unnecessary resist film at the periphery is removed.

The heat-treating apparatus comprises a plurality of baking plates disposed to be adjacent to each other, a cooling plate, and conveying means for conveying the substrate 1. The baking/cooling process is performed by sequentially conveying the substrate 1 held by a pair of openable conveying means to the plurality of baking plates to heat the substrate, and then conveying the substrate to the cooling plate to cool the substrate 1 heated at the preceding step.

The heating temperature and the baking time by the baking plates and the cooling temperature and the cooling time by the cooling plate are appropriately adjusted in accordance with the types of the resist.

### [EXAMPLE 1]

A chromium film and a chromium oxide film were laminated in this order on a synthetic crystal glass substrate having a substrate size of 152.4 x 152.4 x 6.25 mm by sputtering. Thus, a photomask blank having a light-shielding film and a reflection-preventing film was obtained .

Then, a resist film having an average thickness of 4000 Å was formed by spin-coating of FEP171 (FUJIFILM Arch Co., Ltd.), chemically-amplified positive-type electron-beam lithography resist, using the spin-coating apparatus 10 under the following coating conditions:
FEP171 (concentration: 6.2%)
Main rotating speed: 1500 rpm
Main rotating time: 2 sec
Drying rotating speed: 300 rpm
Drying rotating time: 120 sec
Velocity of the airstream toward the substrate: 1 m/sec

As a result, the in-plane-film thickness uniformity of the resist film was 40 Å. The in-plane-film thickness uniformity was determined by the following definition: (the maximum film thickness) - (the minimum film thickness) = (within-film thickness uniformity), and was calculated from in-plane-film thickness distribution data (film thickness data at each measuring point) which was obtained by measuring film thicknesses at equally arranged 121 (11 x 11) points in the central effective area (132 x 132 mm) of the substrate by using a spectro-reflectometry film thickness meter (AFT 6100M: Nanometrics Japan, Ltd.).

The velocity of the airstream was measured by an anemometer.

Then, the substrate having the resist film was mounted on the reduced-pressure drier 20,and was dried under reduced conditions as follows:
A first step: a degree of vacuum of 10 kPa for 1 to 10 sec,
A second step: a degree of vacuum of 1 kPa for 10 to 20 sec, and
A third step: a degree of vacuum of 10 kPa for 1 to 10 sec.

Subsequently, the substrate was conveyed to the unnecessary-film-removing apparatus 30 and the unnecessary resist film deposited at the periphery of the substrate was removed. The periphery of a width of 1.5 mm from the side face of the substrate was removed. Any solvent which can dissolve FEP171 may be used. In this example, use was made of a solvent mixture of propyleneglycol monomethylether acetate (PGMEA) which is used as a solvent (thinner) of FEP171 and propyleneglycol monomethylether (PGME) .

Then, the substrate was conveyed to the above-mentioned baking apparatus for baking and cooling the resist film. In this manner, a mask blank, in which the unnecessary resist film at the periphery was removed, was obtained.

The resulting mask blank had an in-plane-film thickness uniformity of 50 Å. Therefore, the in-plane-film thickness uniformity was almost the same as that of after the deposition of the resist, which is desirable.

### [COMPARATIVE EXAMPLE]

A mask blank was prepared as in EXAMPLE 1 except that the reduced-pressure-drying process was not performed.

An in-plane-film thickness uniformity of the resist film of the mask blank after the baking/cooling process was measured to be 110 Å, which is a decrease in-plane-film thickness uniformity by 70 Å compared to that after the deposition of the resist.

### [EXAMPLE 2]

A mask blank was prepared as in EXAMPLE 1 except that ZEP7000 (ZEON Corporation) was used as a resist. Diglyme (diethyleneglycol dimethylether) was used as a solvent (thinner) in the unnecessary-film-removing process.

The spin-coating conditions were as follows:
Main rotating speed: 1500 rpm
Main rotating time: 10 sec
Drying rotating speed: 200 rpm
Drying rotating time: 120 sec
Velocity of the airstream toward the subtrate: 1 m/sec

As a result, the in-plane-film thickness uniformity of the resist film was 20 Å, and the in-plane-film thickness uniformity of the resist film of the mask blank which was prepared by the unnecessary-film-removing and the baking/cooling processes was 30 A, which is highly desirable.

### [COMPARATIVE EXAMPLE 2]

A mask blank was prepared as in EXAMPLE 2 except that the reduced-pressure-drying process was not performed.

As a result, the resist film of the resulting mask blank after the baking/cooling process had an in-plane-film thickness uniformity of 150 Å, which is a decrease in within-film thickness uniformity by 120 Å compared to that after the deposition of the resist.

A difference in deterioration rate of the in-plane-film thickness uniformity between EXAMPLE 1/COMPARATIVE EXAMPLE 1 and EXAMPLE 2/COMPARATIVE EXAMPLE 2 is thought based on the difference in the types of resist (for example, viscosity).

With the above-mentioned results, in EXAMPLES 1 and 2, the deterioration of in-plane-film thickness uniformity of the resist film in the unnecessary-film-removing process can be reduced to obtain a mask blank provided with a resist film having an in-plane-film thickness uniformity of 50 Å or less. On the other hand, in COMPARATIVE EXAMPLES 1 and 2, the in-plane-film thickness uniformity of the resist film in the unnecessary-film-removing process was degraded, and the in-plane-film thickness uniformity of the resist film exceeded 100 Å.

### Industrial Applicability

According to the present invention, a film of a resist liquid is deposited on a substrate by spin-coating, a covering member covers a surface of the substrate, a solvent is supplied from the upside of the covering member, and unnecessary part of the resist film is removed by to be dissolved with the solvent supplied to the periphery of the substrate during the rotation of the substrate and the covering member together. A partial change in thickness of the resist film caused by the temperature distribution and centrifugal force in the unnecessary-film-removing process can be controlled, and the deterioration of the in-plane-film thickness uniformity of the resist film can be suppressed.

## Claims

1. A method for manufacturing a mask blank by depositing a film of a resist liquid on a substrate including a thin film functioning as a transfer pattern by a spin-coating process; covering the surface of the substrate with a covering member; and performing removal by dissolving of an unnecessary part of the resist film by supplying a solvent from above the covering member during the rotation of the substrate and the covering member together so that the solvent is supplied to the periphery of the substrate, wherein:
a reduced-pressure-drying process for the resist film deposited in the spin-coating process is performed before the unnecessary-film-removing process for removing the unnecessary part of the resist film by dissolving so that a deterioration in an in-plane-film thickness uniformity of the resist film caused by the unnecessary-film-removing process is suppressed.

2. The method for manufacturing the mask blank according to claim 1, wherein:
the spin-coating process is performed in a cup having an opening on an upside by dropping a resist liquid on the surface of the substrate, rotating the substrate at a predetermined rotating speed for a predetermined period of time in order to uniform the film thickness of the resist liquid, and rotating the substrate at a predetermined rotating speed for a predetermined period of time in order to preliminarily dry the film of the resist liquid.

3. The method for manufacturing the mask blank according to claim 2, wherein:
the rotating speed of the substrate for the preliminary drying of the film of the resist liquid is lower than that for uniformizing the film thickness of the resist liquid in the spin-coating process.

4. The method for manufacturing the mask blank according to claim 2 or 3, wherein:
an airstream from the upside of the cup toward the substrate is generated by exhausting at the downside of the cup in the spin-coating process.

5. The method for manufacturing the mask blank according to any one of claims 1 to 4, wherein:
the degree of vacuum in a substrate-receiving space is stepwise decreased in the reduced-pressure-drying process.

6. A method for manufacturing a mask blank, comprising:
depositing a resist liquid dropped on a substrate having a thin film by a spin-coating process;
forming a resist film by drying the deposited film of the resist liquid by a spin-drying process;
drying the resist film by a reduced-pressure-drying process;
supplying a solvent for dissolving the resist film to a periphery of the mask blank on which the resist film is formed; and
removing the resist film at the periphery by rotating the mask blank.

7. The method for manufacturing the mask blank according to any one of claims 1 to 6, wherein:
a difference between a maximum thickness of the resist film and a minimum thickness of the resist film at a region where a transfer pattern is formed is 50 angstroms or less after the removing of the resist film at the periphery.

8. The method for manufacturing the mask blank according to any one of claims 1 to 7, wherein:
the resist film at a region where a transfer pattern is formed comprises the periphery having a thickness not exceeding that of the central part of the mask blank after the removing of the resist film at the periphery.

9. The method for manufacturing the mask blank according to any one of claims 1 to 8, wherein:
the substrate is in a stationary state when the reduced-pressure-drying process is performed.

10. The method for manufacturing the mask blank according to any one of claims 6 to 9, wherein:
the rotating speed of the substrate in the spin-drying process is lower than that in the spin-coating process for depositing the film of the resist liquid.

11. The method for manufacturing the mask blank according to any one of claims 6 to 10, wherein:
the mask blank is heated for drying the resist film after the removing of the resist film at the periphery.
